# EUROPEAN PATENT APPLICATION

(11) **EP 4 847 937 A1**
(43) Date of publication of application: **02.12.2026**
(21) Application number: 26181197.0
(22) Date of filing: 27.05.2026
(51) Int. Cl.: G01R 33/565, G01R 33/567

(54) **METHOD AND APPARATUS FOR DETECTING A RESPIRATION DIRECTION OF A PILOT TONE SIGNAL, AND MAGNETIC RESONANCE IMAGING SYSTEM**

(30) Priority: 30.05.2025 CN 202510727559
(71) Applicant: Siemens Healthineers AG, 91301 Forchheim (DE)
(72) Inventor: HE, Jin Qiang, Shenzhen, GD, 518057 (CN); LI, Wei Ling, Shenzhen, GD, 518057 (CN); TAN, Hui Xin, Shenzhen, GD, 518057 (CN); ZHOU, Kun, Shenzhen, GD, 518057 (CN)
(74) Representative: HKW Intellectual Property PartG mbB

(57) **Abstract**

Embodiments of the present invention disclose a method and apparatus for detecting a respiration direction of a pilot tone signal, and a magnetic resonance imaging system. The method comprises: obtaining a static magnetic field intensity signal of one period in a Z direction acquired by a Hall sensor, wherein the Z direction is a direction perpendicular to a body surface section of an MR scan subject, and the Hall sensor is located in a local coil positioned on the abdomen of the MR scan subject; obtaining a PT signal of the same period of each channel acquired by one or more local coil; taking a respiration direction corresponding to the static magnetic field intensity signal of said one period as a positive respiration direction, and respectively comparing the PT signal of said period of each channel with the static magnetic field intensity signal of said period, to obtain a respiration direction of the PT signal of each channel. Embodiments of the present invention increase the speed and accuracy of detection of PT signal respiration direction.

## Description

### TECHNICAL FIELD

The present invention relates to the technical field of medical imaging, in particular to a method and apparatus for detecting a respiration direction of a pilot tone signal, and an MR (magnetic resonance) imaging system.

### BACKGROUND ART

During MR imaging, a PT (pilot tone) device integrated in a local coil is used to capture various types of physiological movement. An MR imaging sequence and signal acquisition can be triggered or gated at the moment of minimum movement (e.g. the plateau of inhalation or exhalation of the patient, etc.), so as to obtain a high-quality MR image.

The amplitude and phase of the PT signal vary with physiological movement of the scan subject. When multiple PT signal channels are provided, multi-channel PT signals can be obtained from the multiple channels. However, in general, only a high-quality single-channel PT signal reflecting physiological movement (e.g. respiratory movement or heartbeat movement) is needed, and scanning is triggered or gated in the period of minimum movement of this single-channel PT signal, which is formed by combining multi-channel PT signals; typically, between ten and twenty seconds are needed to learn the combination coefficient. Different coil units in an MR imaging system will receive different respiratory movement signals. Consequently, the end of exhalation of some reception channels is at the signal top, whereas the end of exhalation of some reception channels is at the signal bottom. Therefore, the respiration direction (1 or -1) is also a component part of the combination coefficient.

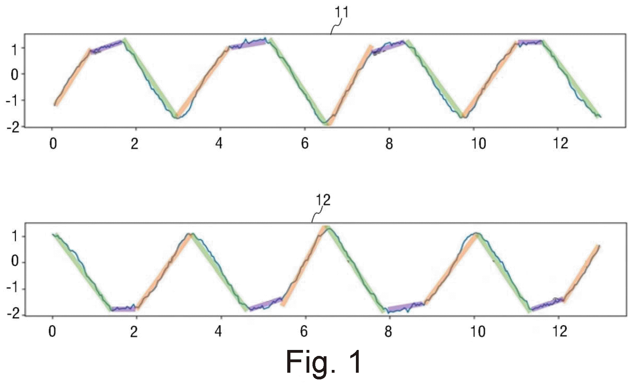

In the configuration of an existing product, the single-channel PT signal finally displayed has the end of exhalation at the bottom. Therefore, if the opposite is true in the PT signal of a particular channel among the multi-channel PT signals, the PT signal of this channel must first be multiplied by -1 to correct its respiration direction before combining the multi-channel PT signals, in order to ensure that the finally synthesized single-channel PT signal has the inhalation phase upward, the exhalation phase downward, and the end of exhalation at the bottom. Fig. 1 is a schematic figure showing a PT signal of a particular channel with the end of exhalation at the top and a corrected PT signal, wherein 11 is a schematic figure of the PT signal of a particular channel with the end of exhalation at the top, and 12 is a schematic figure of the corrected PT signal obtained by multiplying 11 by -1. In 11, the orange part represents the exhalation phase, the purple part represents the end of exhalation, and the green part represents the inhalation phase. In 12, the green part represents the exhalation phase, the purple part represents the end of exhalation, and the orange part represents the inhalation phase. In 11 and 12, the horizontal coordinates are time and the vertical coordinates are PT signal value.

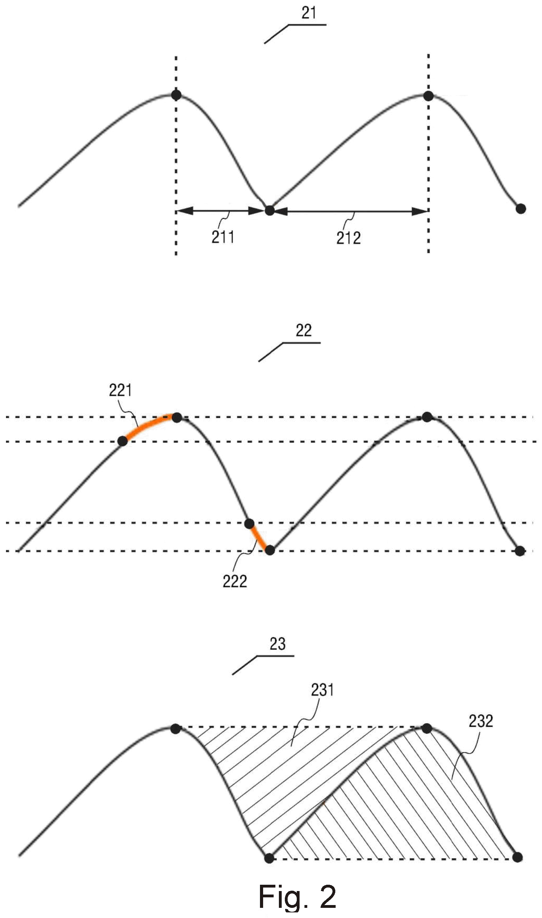

At present, a machine learning method is used to extract a distance characteristic value, a point characteristic value and an area characteristic value from the PT signal of each channel, and these characteristic values are used to determine the respiration phase in the PT signal of the current channel. Fig. 2 is a schematic figure of existing distance characteristic values, point characteristic values and area characteristic values in the PT signal of each channel, extracted by machine learning. 21 is a schematic figure of distance characteristic values, of which there are two: 211 and 212, where 211 is the distance from a peak to a trough of a first respiration period, and 212 is the distance from the trough of the first respiration period to a peak of a second respiration period. 22 is a schematic figure of point characteristic values, of which there are two: 221 and 222, where 221 is the number of points between 80% of a peak and the peak in a rising phase of one respiration period, and 222 is the number of points between 20% of the peak and a trough in a falling phase of one respiration period. 23 is a schematic figure of area characteristic values, of which there are two: 231 and 232, where 231 is an area enclosed between peaks of two adjacent respiration periods, and 232 is an area enclosed between troughs of two adjacent respiration periods.

The solution whereby a machine learning method is used to determine the respiration phase in the PT signal of each channel only uses signal characteristics to indirectly judge the respiration direction. However, in certain special cases, for example when a patient has an unnatural respiration process due to physical reasons, or when signal processing is incorrect, the above characteristics cannot be extracted properly, and this will affect the judgment result.

In addition, during MR imaging, the patient is sometimes required to perform specific respiratory actions, such as holding the breath or inhaling. To ensure that the patient's respiratory actions can be performed properly, a technician needs to give the patient respiration training before formal scanning begins. In order to monitor whether the patient's respiratory actions are performed properly, respiratory movements of the patient must be acquired via a local coil; multi-channel PT signals are then combined, and the single-channel PT signal obtained is displayed to the technician, allowing the technician to check whether the patient's respiratory actions are performed properly. As can be seen, the patient's respiration training can only begin after waiting for the coil to be plugged in for the patient and the combination coefficient of the multi-channel PT signals to be learned; typically, this waiting process is approximately between ten and twenty seconds, spoiling the user experience.

### SUMMARY OF THE INVENTION

In view of the above, one aspect of embodiments of the present invention proposes a method and apparatus for detecting a respiration direction of a PT signal, to increase the speed and accuracy of detection of the respiration direction of the PT signal; another aspect of embodiments of the present invention proposes an MR imaging system, to increase the speed and accuracy of detection of the respiration direction of the PT signal.

A method for detecting a respiration direction of a pilot tone signal, the method comprising:
obtaining a static magnetic field intensity signal of one period in a Z direction acquired by a Hall sensor, wherein the Z direction is a direction perpendicular to a body surface section of a magnetic resonance (MR) scan subject, the Hall sensor is located in a local coil positioned on the abdomen of the MR scan subject, and the local coil is located in a scanning range of an MR scanning apparatus;
obtaining a pilot tone signal of one period of each channel acquired by one or more local coil, wherein the pilot tone signal of one period of each channel belongs to the same period pilot tone as the static magnetic field intensity signal of said one period, and the one or more local coil is located in the scanning range of the MR scanning apparatus;
taking a respiration direction corresponding to the static magnetic field intensity signal of said one period as a positive respiration direction, and respectively comparing the pilot tone signal of said period of each channel with the static magnetic field intensity signal of said period, to obtain a respiration direction of the pilot tone signal of each channel.

After the step of obtaining a respiration direction of the pilot tone signal of each channel, the method further comprises:
for pilot tone signals of a current period and subsequent periods of each channel, combining the pilot tone signals of each channel to form a single-channel pilot tone signal, according to the respiration direction of the pilot tone signal of each channel.

The step of respectively comparing the pilot tone signal of said period of each channel with the static magnetic field intensity signal of said period comprises:
for the pilot tone signal of said period of each channel, calculating a correlation coefficient of the pilot tone signal of said period of said channel and the static magnetic field intensity signal of said period, and if the correlation coefficient is greater than a first threshold, determining that a respiration direction of the pilot tone signal of said channel is the same as a respiration direction of the static magnetic field intensity signal.

The step of respectively comparing the pilot tone signal of said period of each channel with the static magnetic field intensity signal of said period comprises:
for the pilot tone signal of said period of each channel, calculating the absolute value of a first difference between a trough position of the pilot tone signal of said period of said channel and a trough position of the static magnetic field intensity signal of said period, calculating the absolute value of a second difference between a peak position of the pilot tone signal of said period of said channel and a peak position of the static magnetic field intensity signal of said period, and if the absolute value of the first difference is less than a second threshold and the absolute value of the second difference is less than a third threshold, determining that a respiration direction of the pilot tone signal of said channel is the same as a respiration direction of the static magnetic field intensity signal.

The step of respectively comparing the pilot tone signal of said period of each channel with the static magnetic field intensity signal of said period comprises:
subtracting a DC component of the static magnetic field intensity signal from the static magnetic field intensity signal of said period, obtaining positions of two zero points from a resulting difference signal, and summing a signal between the two zero points to obtain a first sum;
for the pilot tone signal of said period of each channel, subtracting a DC component of the pilot tone signal from the pilot tone signal of said period of said channel, obtaining positions of two zero points from a resulting difference signal, and summing a signal between the two zero points to obtain a second sum;
judging whether the first sum and the second sum are both positive or both negative, and if so, determining that a respiration direction of the pilot tone signal of said channel is the same as a respiration direction of the static magnetic field intensity signal.

The step of respectively comparing the pilot tone signal of said period of each channel with the static magnetic field intensity signal of said period comprises:
for the pilot tone signal of said period of each channel, simultaneously inputting the pilot tone signal of said period of said channel and the static magnetic field intensity signal of said period into a pre-trained respiration direction detection model, and if an output value of the model is greater than a fourth threshold, determining that a respiration direction of the pilot tone signal of said channel is the same as a respiration direction of the static magnetic field intensity signal.

An apparatus for detecting a respiration direction of a pilot tone signal, the apparatus comprising:
a static magnetic field intensity signal obtaining module, for obtaining a static magnetic field intensity signal of one period in a Z direction acquired by a Hall sensor, wherein the Z direction is a direction perpendicular to a body surface section of a magnetic resonance (MR) scan subject, the Hall sensor is located in a local coil positioned on the abdomen of the MR scan subject, and the local coil is located in a scanning range of an MR scanning apparatus;
a pilot tone obtaining module, for obtaining a pilot tone signal of one period of each channel acquired by one or more local coil, wherein the pilot tone signal of one period of each channel belongs to the same period as the static magnetic field intensity signal of said one period, and the one or more local coil is located in the scanning range of the MR scanning apparatus;
a comparison module, for taking a respiration direction corresponding to the static magnetic field intensity signal of said one period as a positive respiration direction, and respectively comparing the pilot tone signal of said period of each channel with the static magnetic field intensity signal of said period, to obtain a respiration direction of the pilot tone signal of each channel.

The apparatus further comprises: a multi-channel combining module which, for pilot tone signals of a current period and subsequent periods of each channel, combines the pilot tone signals of each channel to form a single-channel pilot tone signal, according to the respiration direction of the pilot tone signal of each channel.

The comparison module respectively comparing the pilot tone signal of said period of each channel with the static magnetic field intensity signal of said period comprises:
for the pilot tone signal of said period of each channel, calculating a correlation coefficient of the pilot tone signal of said period of said channel and the static magnetic field intensity signal of said period, and if the correlation coefficient is greater than a first threshold, determining that a respiration direction of the pilot tone signal of said channel is the same as a respiration direction of the static magnetic field intensity signal.

The comparison module respectively comparing the pilot tone signal of said period of each channel with the static magnetic field intensity signal of said period comprises:
for the pilot tone signal of said period of each channel, calculating the absolute value of a first difference between a trough position of the pilot tone signal of said period of said channel and a trough position of the static magnetic field intensity signal of said period, calculating the absolute value of a second difference between a peak position of the pilot tone signal of said period of said channel and a peak position of the static magnetic field intensity signal of said period, and if the absolute value of the first difference is less than a second threshold and the absolute value of the second difference is less than a third threshold, determining that a respiration direction of the pilot tone signal of said channel is the same as a respiration direction of the static magnetic field intensity signal.

The comparison module respectively comparing the pilot tone signal of said period of each channel with the static magnetic field intensity signal of said period comprises:
subtracting a DC component of the static magnetic field intensity signal from the static magnetic field intensity signal of said period, obtaining positions of two zero points from a resulting difference signal, and summing a signal between the two zero points to obtain a first sum;
for the pilot tone signal of said period of each channel, subtracting a DC component of the pilot tone signal from the pilot tone signal of said period of said channel, obtaining positions of two zero points from a resulting difference signal, and summing a signal between the two zero points to obtain a second sum;
judging whether the first sum and the second sum are both positive or both negative, and if so, determining that a respiration direction of the pilot tone signal of said channel is the same as a respiration direction of the static magnetic field intensity signal.

The comparison module respectively comparing the pilot tone signal of said period of each channel with the static magnetic field intensity signal of said period comprises:
for the pilot tone signal of said period of each channel, simultaneously inputting the pilot tone signal of said period of said channel and the static magnetic field intensity signal of said period into a pre-trained respiration direction detection model, and if an output value of the model is greater than a fourth threshold, determining that a respiration direction of the pilot tone signal of said channel is the same as a respiration direction of the static magnetic field intensity signal.

A magnetic resonance imaging system, comprising the apparatus for detecting a respiration direction of a pilot tone signal as described in any one of the embodiments above.

In embodiments of the present invention, by means of the Hall sensor in the local coil positioned on the abdomen of the MR scan subject, a static magnetic field intensity signal of one period in a direction perpendicular to a body surface section of the MR scan subject acquired by a Hall sensor is obtained, and at the same time, a PT signal of one period of each channel acquired by one or more local coil is obtained; and, taking a respiration direction corresponding to the static magnetic field intensity signal of one period as a positive respiration direction, the PT signal of said period of each channel is respectively compared with the static magnetic field intensity signal of said period, to obtain a respiration direction of the PT signal of each channel. Since the Hall sensor is positioned directly above the abdomen of the MR scan subject, as the MR scan subject breathes, variation in the static magnetic field intensity signal in the direction perpendicular to the body surface section of the MR scan subject acquired by the Hall sensor is precisely in synchrony with variation in a respiration signal having the end of exhalation at the bottom. Based on this characteristic, the static magnetic field intensity signal of one period in the direction perpendicular to the body surface section of the MR scan subject acquired by the Hall sensor can be taken to be the positive respiration direction, and the respiration direction of the PT signal of each channel can be obtained directly by comparing the PT signal of the same period of each channel with the static magnetic field intensity signal of said period, thereby increasing the speed and accuracy of detection of PT signal respiration direction.

### BRIEF DESCRIPTION OF THE DRAWINGS

Preferred embodiments of the present invention will be described in detail below with reference to the drawings, to give those skilled in the art a clearer understanding of the abovementioned and other features and advantages of the present invention. In the drawings:
Fig. 1 is a schematic figure showing a PT signal of a particular channel with the end of exhalation at the top and a corrected PT signal.
Fig. 2 is a schematic figure of existing distance characteristic values, point characteristic values and area characteristic values in a PT signal of each channel, extracted by machine learning.
Fig. 3 is a flow chart of a method for detecting a respiration direction of a PT signal provided in an embodiment of the present invention.
Fig. 4 is a schematic drawing of a B0 field intensity signal being acquired by a Hall sensor in a local coil positioned on the abdomen of an MR scan subject in an application example of the present invention.
Fig. 5 is a schematic drawing of intensity components of a B0 field in three directions: the X, Y and Z directions.
Fig. 6 is a schematic figure of a B0 field intensity signal in the Z direction acquired by a Hall sensor, and a single-channel PT signal obtained by combining multi-channel PT signals, in an application example of the present invention.
Fig. 7 is a structural schematic drawing of an apparatus for detecting a respiration direction of a PT signal provided in an embodiment of the present invention.

### KEY TO THE DRAWINGS

| Label | Meaning |
|---|---|
| 11 | PT signal of particular channel with end of exhalation at the top |
| 12 | Corrected PT signal obtained by multiplying 11 by -1 |
| 21 | Schematic figure of distance characteristic values |
| 211 | Distance from peak to trough of first respiration period |
| 212 | Distance from trough of first respiration period to peak of second respiration period |
| 22 | Schematic figure of point characteristic values |
| 221 | Number of points between 80% of peak and peak in rising phase of one respiration period |
| 222 | Number of points between 20% of peak and trough in falling phase of one respiration period. |
| 23 | Schematic figure of area characteristic values |
| 231 | Area enclosed between peaks of two adjacent respiration periods |
| 232 | Area enclosed between troughs of two adjacent respiration periods |
| 301 - 303 | Steps |
| 41 | Z direction |
| 40 | B0 field direction |
| 50 | Local coil |
| 61 | Single-channel PT signal |
| 62 | B0 field intensity signal in Z direction acquired by Hall sensor |
| 70 | Apparatus for detecting respiration direction of PT signal |
| 71 | B0 field intensity signal obtaining module |
| 72 | PT signal obtaining module |
| 73 | Comparison module |

### DETAILED DESCRIPTION OF EMBODIMENTS

To clarify the objective, technical solution and advantages of the present invention, the present invention is described in further detail below through embodiments.

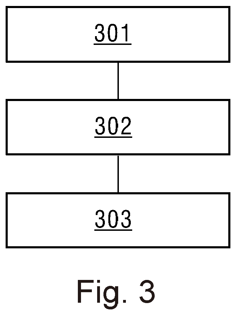

Fig. 3 is a flow chart of a method for detecting a respiration direction of a PT signal provided in an embodiment of the present invention. As shown in Fig. 3, the specific steps thereof are as follows:
Step 301: obtaining a static magnetic field (BO field) intensity signal of one period in a Z direction acquired by a Hall sensor, wherein the Z direction is a direction perpendicular to a body surface section of an MR scan subject, the Hall sensor is located in a local coil positioned on the abdomen of the MR scan subject, and the local coil is located in a scanning range of an MR scanning apparatus.

Here, the local coil being located in the scanning range of the MR scanning apparatus means that the local coil has already been properly placed on the abdomen of the MR scan subject, and the MR scan subject has already been pushed to the magnet center of the MR scanning apparatus, and PT signal acquisition has already begun.

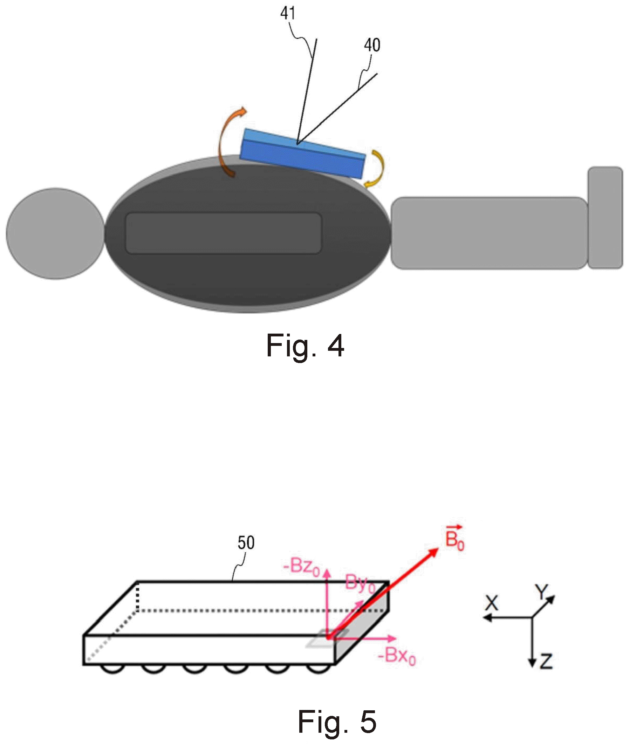

Fig. 4 is a schematic drawing of a B0 field intensity signal being acquired by a Hall sensor in a local coil positioned on the abdomen of an MR scan subject in an application example of the present invention. The local coil contains 3 Hall sensors, used to respectively acquire intensity components of the B0 field in three directions, each pair of the three directions being mutually perpendicular. One direction is the direction perpendicular to the body surface section of the MR scan subject (set as the Z direction, i.e. the direction indicated by 41 in the figure; if the local coil is a standard cuboid, the Z direction is the direction perpendicular to an upper surface of the local coil). The other two directions are parallel to the body surface section of the MR scan subject (set as the X and Y directions respectively; if the local coil is a standard cuboid, the X and Y directions are the directions of two edges of the upper surface of the local coil). As the MR scan subject breathes, the abdomen of the MR scan subject rises and falls. As the abdomen of the MR scan subject is rising and falling, the body surface section of the MR scan subject rotates slightly up and down about a central point continuously. Thus, the local coil also rotates slightly up and down about a central point continuously. Moreover, since the local coil is placed on the abdomen, within a single respiratory movement, the local coil rotates through a larger angular range at a side close to the chest, and rotates through a smaller angular range at a side close to the abdomen. Thus, within a single respiratory movement, the angle between the Z direction and the B0 field direction (i.e. the direction indicated by 40 in the figure) varies, and consequently: during inhalation, the intensity component of B0 field in the Z direction increases, and during exhalation, the intensity component of B0 field in the Z direction decreases. The pattern of this variation is exactly in synchrony with the pattern of variation of a respiration signal (such as a PT signal). Thus, variation of the intensity component of B0 field in the Z direction can fully represent variation of respiration state.

Fig. 5 is a schematic drawing of intensity components of the B0 field in three directions: the X, Y and Z directions. *̅B̅*̅₀̅ is the B0 field; -*B*_{*x*₀}*, B*_{*y*₀} and -*B*_{*z*₀} are the intensity components of the B0 field in the X, Y and Z directions respectively; and 50 is a local coil.

Step 302: obtaining a PT signal of one period of each channel acquired by one or more local coil, wherein the PT signal of one period of each channel belongs to the same period as the B0 field intensity signal of one period acquired in step 301, and the one or more local coil is located in the scanning range of the MR scanning apparatus.

Here, the local coil being located in the scanning range of the MR scanning apparatus means that the local coil has already been properly placed on the chest or abdomen of the MR scan subject, and the MR scan subject has already been pushed to the magnet center of the MR scanning apparatus, and PT scanning has already begun.

There might be multiple local coils in a single MR imaging operation, wherein at least one local coil must be positioned on the abdomen of the MR scan subject, because the Hall sensor in step 301 must be positioned in a local coil on the abdomen. In addition, depending on imaging needs, it might also be necessary to position a local coil on the chest of the MR scan subject.

Step 303: taking a respiration direction corresponding to the B0 field intensity signal of one period acquired in step 301 as a positive respiration direction, and respectively comparing the PT signal of said period of each channel with the B0 field intensity signal of said period, to obtain a respiration direction of the PT signal of each channel.

When the end of exhalation of the B0 field intensity signal of one period is at the bottom of the B0 field intensity signal of an entire period, the positive respiration direction is a respiration direction corresponding to a respiration signal in which the end of exhalation is at the bottom.

In actual application, before respectively comparing the PT signal of said period of each channel with the B0 field intensity signal of said period, the PT signal of said period of each channel may first be subjected to interference removal processing, to increase the accuracy of respiration direction detection. Interference removal algorithms are mature technology, and are not specifically limited here.

After detecting the respiration direction of the PT signal of each channel, the respiration direction of the PT signal of each channel can be recorded, and the PT signals of each channel can be combined according to the respiration directions of the PT signals of each channel, to obtain a single-channel PT signal. Thereafter, as long as no new PT signal channels are added, there is no need to perform detection of PT signal respiration directions again. Only if a new PT signal channel is added, will detection of the respiration direction of the PT signal of this newly added channel be performed according to steps 301 - 303 above.

In an optional embodiment, after obtaining the respiration direction of the PT signal of each channel in step 303, the method further comprises: for PT signals of a current period and subsequent periods of each channel, combining the PT signals of each channel to form a single-channel PT signal, according to the respiration direction of the PT signal of each channel. For example, if the respiration direction of the PT signal of a particular channel is opposite to the respiration direction of the B0 field intensity signal, a respiration direction coefficient of that channel is determined as being -1, otherwise the respiration direction coefficient of that channel is determined as being 1. Before combining the PT signals of each channel, the PT signal of each channel must first be multiplied by its respective respiration direction coefficient, and a subsequent combining process is then performed.

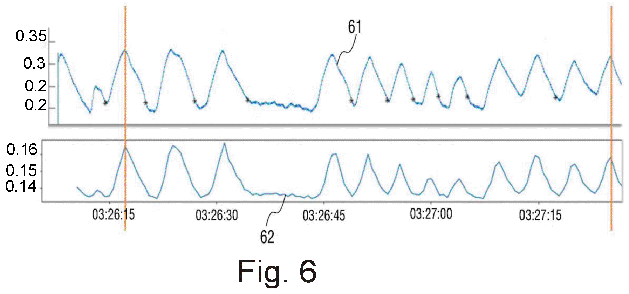

Fig. 6 is a schematic figure of a B0 field intensity signal in the Z direction acquired by a Hall sensor, and a single-channel PT signal obtained by combining multi-channel PT signals, in an application example of the present invention. 61 is the single-channel PT signal, and 62 is the B0 field intensity signal in the Z direction acquired by the Hall sensor. As can be seen, the two signals vary in exact synchrony, wherein the horizontal coordinates of 61 and 62 are signal acquisition time points, and the vertical coordinates are signal values.

In actual applications, the B0 field intensity signal can be displayed in real time, while labeling a respiration state of each segment of the signal, the respiration states including: an inhalation phase (i.e. a rising phase of the B0 field intensity signal), an exhalation phase (i.e. a falling phase of the B0 field intensity signal), and end of exhalation (i.e. a plateau at the end of the falling phase of the B0 field intensity signal).

In the above embodiments, by means of the Hall sensor in the local coil positioned on the abdomen of the MR scan subject, since the Hall sensor is positioned directly above the abdomen of the MR scan subject, as the MR scan subject breathes, variation in the B0 field intensity signal in the direction perpendicular to the body surface section of the MR scan subject acquired by the Hall sensor is precisely in synchrony with variation in a respiration signal having the end of exhalation at the bottom. Based on this characteristic, the B0 field intensity signal of one period in the direction perpendicular to the body surface section of the MR scan subject acquired by the Hall sensor can be taken to be the positive respiration direction, and the respiration direction of the PT signal of each channel can be obtained directly by comparing the PT signal of the same period of each channel with the B0 field intensity signal of said period, thereby increasing the speed and accuracy of detection of PT signal respiration direction.

It can also be seen from the above embodiments that: it is only necessary to acquire the PT signal of each channel and the B0 field intensity signal of one full period before beginning detection of the respiration direction of the PT signal of each channel, so the speed of detection is very quick; moreover, by directly using the B0 field intensity signal in the direction perpendicular to the body surface section of the MR scan subject as the positive respiration direction, and directly comparing the PT signal of the same period of each channel with the B0 field intensity signal, the respiration direction of the PT signal of each channel can be obtained directly, and this also increases the speed and accuracy of detection of PT signal respiration direction.

Similarly, it can also be seen from the above embodiments that: since the Hall sensor can directly acquire a B0 field intensity signal of positive respiration, once the MR scan subject has been pushed to the magnet center of the MR scanning apparatus, the B0 field intensity signal can be displayed as a respiration signal of positive respiration, and the technician can give the MR scan subject respiration training directly according to this signal; at the same time, the respiration direction of the PT signal of each channel is detected in the background synchronously according to the B0 field intensity signal, and multi-channel PT signals are combined after detecting the respiration direction, thus reducing the time required for the entire MR examination and improving the user experience.

In an optional embodiment, respectively comparing the PT signal of said period of each channel with the B0 field intensity signal of said period in step 303 comprises: for the PT signal of said period of each channel, calculating a correlation coefficient of the PT signal of said period of said channel and the B0 field intensity signal of said period, and if the correlation coefficient is greater than a first threshold, determining that a respiration direction of the PT signal of said channel is the same as a respiration direction of the B0 field intensity signal. Since the calculation of correlation is mature technology, the associated algorithm used when calculating the correlation coefficient is not limited here. The specific value of the first threshold may be determined according to multiple tests.

The following is taken into account: when the respiration directions of the B0 field intensity signal and the PT signal of a particular channel are the same, the peak positions of the B0 field intensity signal and the PT signal of the same period are theoretically the same position (wherein the peak position may be represented as a signal acquisition time point), and the trough positions of the two signals are theoretically the same position (wherein the trough position may be represented as a signal acquisition time point). Therefore:
In an optional embodiment, respectively comparing the PT signal of said period of each channel with the B0 field intensity signal of said period in step 303 comprises: for the PT signal of said period of each channel, calculating the absolute value of a first difference between a trough position of the PT signal of said period of said channel and a trough position of the B0 field intensity signal of said period, calculating the absolute value of a second difference between a peak position of the PT signal of said period of said channel and a position peak of the B0 field intensity signal of said period, and if the absolute value of the first difference is less than a second threshold and the absolute value of the second difference is less than a third threshold, determining that a respiration direction of the PT signal of said channel is the same as a respiration direction of the B0 field intensity signal. The specific values of the second threshold and the third threshold can be determined by multiple tests. The peak positions and the trough positions are time points corresponding to peaks and troughs.

For example: for the PT signal of said period of each channel, a trough position and a peak position of the PT signal of said period of said channel are calculated as trough_PT and peak_PT, respectively; and a trough position and a peak position of the B0 field intensity signal of said period are calculated as trough_hall and peak_hall, respectively. Then if | trough_PT - trough_hall | < Th2 and | peak_PT - peak_hall | < Th3, it is determined that a respiration direction of the PT signal of said channel is the same as a respiration direction of the B0 field intensity signal, wherein Th2 and Th3 are the second threshold and the third threshold, respectively.

In an optional embodiment, respectively comparing the PT signal of said period of each channel with the B0 field intensity signal of said period in step 303 comprises: subtracting a DC component of the B0 field intensity signal from the B0 field intensity signal of said period, obtaining positions of two zero points from a resulting difference signal, and summing a signal between the two zero points to obtain a first sum; for the PT signal of said period of each channel, subtracting a DC component of the PT signal from the PT signal of said period of said channel, obtaining positions of two zero points from a resulting difference signal, and summing a signal between the two zero points to obtain a second sum; judging whether the first sum and the second sum are both positive or both negative, and if so, determining that a respiration direction of the PT signal of said channel is the same as a respiration direction of the B0 field intensity signal. The DC component of the B0 field intensity signal may be the mean value of the B0 field intensity signal in said period, and the DC component of the PT signal may be the mean value of the PT signal of said period of said channel.

For example: if the first sum is sum_hall and the second sum is sum_PT, then: if sum_hall > 0 and sum_PT > 0, or sum_hall < 0 and sum_PT < 0, it is determined that a respiration direction of the PT signal of said channel is the same as a respiration direction of the B0 field intensity signal.

In an optional embodiment, respectively comparing the PT signal of said period of each channel with the B0 field intensity signal of said period in step 303 comprises: for the PT signal of said period of each channel, simultaneously inputting the PT signal of said period of said channel and the B0 field intensity signal of said period into a pre-trained respiration direction detection model, and if an output value of the model is greater than a fourth threshold, determining that a respiration direction of the PT signal of said channel is the same as a respiration direction of the B0 field intensity signal. The specific value of the fourth threshold can be determined by multiple tests.

When training the respiration direction detection model, each training sample in a training sample set comprises two signals: one signal is a B0 field intensity signal of positive respiration, the other signal is a PT signal of positive or negative respiration, and if the PT signal is positive respiration, a training target value of said sample is 1, otherwise the training target value is -1. After training begins, a training sample is successively taken, the two signals in this training sample are simultaneously inputed into the respiration direction detection model, a loss function is calculated according to the training target value and the output of the model, and model parameters are adjusted according to the value of the loss function, until the model converges.

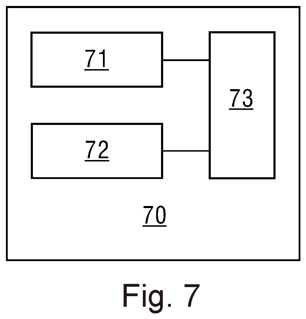

Fig. 7 is a structural schematic drawing of an apparatus 70 for detecting a respiration direction of a PT signal provided in an embodiment of the present invention. As shown in Fig. 7, it mainly comprises: a B0 field intensity signal obtaining module 71, a PT signal obtaining module 72 and a comparison module 73, wherein:
The B0 field intensity signal obtaining module 71 obtains a B0 field intensity signal of one period in a Z direction acquired by a Hall sensor, wherein the Z direction is a direction perpendicular to a body surface section of an MR scan subject, the Hall sensor is located in a local coil positioned on the abdomen of the MR scan subject, and the local coil is located in a scanning range of an MR scanning apparatus.

The PT signal obtaining module 72 obtains a PT signal of one period of each channel acquired by one or more local coil, wherein the PT signal of one period of each channel belongs to the same period as the B0 field intensity signal of one period mentioned above, and the one or more local coil is located in the scanning range of the MR scanning apparatus.

The comparison module 73 takes a respiration direction corresponding to the B0 field intensity signal of one period mentioned above as a positive respiration direction, and respectively compares the PT signal of said period of each channel with the B0 field intensity signal of said period, to obtain a respiration direction of the PT signal of each channel.

In an optional embodiment, the apparatus 70 further comprises: a multi-channel combining module which, for PT signals of a current period and subsequent periods of each channel, combines the PT signals of each channel to form a single-channel PT signal, according to the respiration direction of the PT signal of each channel.

In an optional embodiment, the comparison module 73 respectively comparing the PT signal of said period of each channel with the B0 field intensity signal of said period comprises: for the PT signal of said period of each channel, calculating a correlation coefficient of the PT signal of said period of said channel and the B0 field intensity signal of said period, and if the correlation coefficient is greater than a first threshold, determining that a respiration direction of the PT signal of said channel is the same as a respiration direction of the B0 field intensity signal.

In an optional embodiment, the comparison module 73 respectively comparing the PT signal of said period of each channel with the B0 field intensity signal of said period comprises: for the PT signal of said period of each channel, calculating the absolute value of a first difference between a trough position of the PT signal of said period of said channel and a trough position of the B0 field intensity signal of said period, calculating the absolute value of a second difference between a peak position of the PT signal of said period of said channel and a peak position of the B0 field intensity signal of said period, and if the absolute value of the first difference is less than a second threshold and the absolute value of the second difference is less than a third threshold, determining that a respiration direction of the PT signal of said channel is the same as a respiration direction of the B0 field intensity signal.

In an optional embodiment, the comparison module 73 respectively comparing the PT signal of said period of each channel with the B0 field intensity signal of said period comprises: subtracting a DC component of the B0 field intensity signal from the B0 field intensity signal of said period, obtaining positions of two zero points from a resulting difference signal, and summing a signal between the two zero points to obtain a first sum; for the PT signal of said period of each channel, subtracting a DC component of the PT signal from the PT signal of said period of said channel, obtaining positions of two zero points from a resulting difference signal, and summing a signal between the two zero points to obtain a second sum; judging whether the first sum and the second sum are both positive or both negative, and if so, determining that a respiration direction of the PT signal of said channel is the same as a respiration direction of the B0 field intensity signal.

In an optional embodiment, the comparison module 73 respectively comparing the PT signal of said period of each channel with the B0 field intensity signal of said period comprises: for the PT signal of said period of each channel, simultaneously inputting the PT signal of said period of said channel and the B0 field intensity signal of said period into a pre-trained respiration direction detection model, and if an output value of the model is greater than a fourth threshold, determining that a respiration direction of the PT signal of said channel is the same as a respiration direction of the B0 field intensity signal.

Embodiments of the present invention further provide an MR imaging system, comprising the apparatus 70 for detecting a respiration direction of a PT signal as described in any one of the embodiments above.

It should be explained that the method and apparatus for detecting a respiration direction of a PT signal and the MR imaging system provided in embodiments of the present invention may be a method, apparatus and system applied in medical imaging.

Embodiments of the present invention further provide a computer program product, comprising a computer program or instruction which, when executed by a processor, implements the steps of the method for detecting a respiration direction of a PT signal as described in any one of the embodiments above.

Embodiments of the present invention further provide a computer-readable storage medium, storing an instruction which, when executed by a processor, can execute the steps of the method for detecting a respiration direction of a PT signal as described above. In practical applications, the computer-readable medium may be included in each device/apparatus/system in the above embodiments, or may exist independently without being fitted into the device/apparatus/system. An instruction is stored in the computer-readable storage medium, and the instruction stored therein, when executed by a processor, can execute the steps of the method for detecting a respiration direction of a PT signal as described above.

Embodiments of the present invention further provide an electronic device. The electronic device may comprise a processor with one or more processing cores, a memory with one or more computer-readable storage media, and a computer program stored in the memory and executable on the processor. When the program in the memory is executed, the method for detecting a respiration direction of a PT signal as described above can be implemented.

Those skilled in the art will understand that features stated in the various embodiments and/or claims disclosed in the present application can be combined and/or integrated in various ways, even if such combinations or integrations are not explicitly stated in the present application. In particular, without departing from the spirit and teaching of the present application, features stated in the various embodiments and/or claims of the present application can be combined and/or integrated in various ways, and all such combinations and/or integrations fall within the scope of disclosure of the present application.

Specific embodiments have been used herein to expound the principles and implementations of the present application, but the description of the embodiments above is merely intended to assist understanding of the method of the present application and the core idea thereof, not to restrict the present application. Those skilled in the art could make changes to specific implementations and scope of application, based on the idea, spirit and principles of the present application, and any modifications, equivalent replacements, improvements, etc., made by those skilled in the art should be included within the scope of protection of the present application.

## Claims

1. A method for detecting a respiration direction of a pilot tone signal, **characterized in that** the method comprises:
obtaining a static magnetic field intensity signal of one period in a Z direction acquired by a Hall sensor, wherein the Z direction is a direction perpendicular to a body surface section of a magnetic resonance (MR) scan subject, the Hall sensor is located in a local coil positioned on the abdomen of the MR scan subject, and the local coil is located in a scanning range of an MR scanning apparatus;
obtaining a pilot tone signal of one period of each channel acquired by one or more local coil, wherein the pilot tone signal of one period of each channel belongs to the same period pilot tone as the static magnetic field intensity signal of said one period, and the one or more local coil is located in the scanning range of the MR scanning apparatus;
taking a respiration direction corresponding to the static magnetic field intensity signal of said one period as a positive respiration direction, and respectively comparing the pilot tone signal of said period of each channel with the static magnetic field intensity signal of said period, to obtain a respiration direction of the pilot tone signal of each channel.

2. The method as claimed in claim 1, **characterized in that**, after the step of obtaining a respiration direction of the pilot tone signal of each channel, the method further comprises:
for pilot tone signals of a current period and subsequent periods of each channel, combining the pilot tone signals of each channel to form a single-channel pilot tone signal, according to the respiration direction of the pilot tone signal of each channel.

3. The method as claimed in claim 1, **characterized in that** the step of respectively comparing the pilot tone signal of said period of each channel with the static magnetic field intensity signal of said period comprises:
for the pilot tone signal of said period of each channel, calculating a correlation coefficient of the pilot tone signal of said period of said channel and the static magnetic field intensity signal of said period, and if the correlation coefficient is greater than a first threshold, determining that a respiration direction of the pilot tone signal of said channel is the same as a respiration direction of the static magnetic field intensity signal.

4. The method as claimed in claim 1, **characterized in that** the step of respectively comparing the pilot tone signal of said period of each channel with the static magnetic field intensity signal of said period comprises:
for the pilot tone signal of said period of each channel, calculating the absolute value of a first difference between a trough position of the pilot tone signal of said period of said channel and a trough position of the static magnetic field intensity signal of said period, calculating the absolute value of a second difference between a peak position of the pilot tone signal of said period of said channel and a peak position of the static magnetic field intensity signal of said period, and if the absolute value of the first difference is less than a second threshold and the absolute value of the second difference is less than a third threshold, determining that a respiration direction of the pilot tone signal of said channel is the same as a respiration direction of the static magnetic field intensity signal.

5. The method as claimed in claim 1, **characterized in that** the step of respectively comparing the pilot tone signal of said period of each channel with the static magnetic field intensity signal of said period comprises:
subtracting a DC component of the static magnetic field intensity signal from the static magnetic field intensity signal of said period, obtaining positions of two zero points from a resulting difference signal, and summing a signal between the two zero points to obtain a first sum;
for the pilot tone signal of said period of each channel, subtracting a DC component of the pilot tone signal from the pilot tone signal of said period of said channel, obtaining positions of two zero points from a resulting difference signal, and summing a signal between the two zero points to obtain a second sum;
judging whether the first sum and the second sum are both positive or both negative, and if so, determining that a respiration direction of the pilot tone signal of said channel is the same as a respiration direction of the static magnetic field intensity signal.

6. The method as claimed in claim 1, **characterized in that** the step of respectively comparing the pilot tone signal of said period of each channel with the static magnetic field intensity signal of said period comprises:
for the pilot tone signal of said period of each channel, simultaneously inputting the pilot tone signal of said period of said channel and the static magnetic field intensity signal of said period into a pre-trained respiration direction detection model, and if an output value of the model is greater than a fourth threshold, determining that a respiration direction of the pilot tone signal of said channel is the same as a respiration direction of the static magnetic field intensity signal.

7. An apparatus for detecting a respiration direction of a pilot tone signal, **characterized in that** the apparatus comprises:
a static magnetic field intensity signal obtaining module, for obtaining a static magnetic field intensity signal of one period in a Z direction acquired by a Hall sensor, wherein the Z direction is a direction perpendicular to a body surface section of a magnetic resonance (MR) scan subject, the Hall sensor is located in a local coil positioned on the abdomen of the MR scan subject, and the local coil is located in a scanning range of an MR scanning apparatus;
pilot tone obtaining module, for obtaining a pilot tone signal of one period of each channel acquired by one or more local coil, wherein the pilot tone signal of one period of each channel belongs to the same period as the static magnetic field intensity signal of said one period, and the one or more local coil is located in the scanning range of the MR scanning apparatus;
a comparison module, for taking a respiration direction corresponding to the static magnetic field intensity signal of said one period as a positive respiration direction, and respectively comparing the pilot tone signal of said period of each channel with the static magnetic field intensity signal of said period, to obtain a respiration direction of the pilot tone signal of each channel.

8. The apparatus as claimed in claim 7, **characterized in that** the apparatus further comprises: a multi-channel combining module which, for pilot tone signals of a current period and subsequent periods of each channel, combines the pilot tone signals of each channel to form a single-channel pilot tone signal, according to the respiration direction of the pilot tone signal of each channel.

9. The apparatus as claimed in claim 7, **characterized in that** the comparison module respectively comparing the pilot tone signal of said period of each channel with the static magnetic field intensity signal of said period comprises:
for the pilot tone signal of said period of each channel, calculating a correlation coefficient of the pilot tone signal of said period of said channel and the static magnetic field intensity signal of said period, and if the correlation coefficient is greater than a first threshold, determining that a respiration direction of the pilot tone signal of said channel is the same as a respiration direction of the static magnetic field intensity signal.

10. The apparatus as claimed in claim 7, **characterized in that** the comparison module respectively comparing the pilot tone signal of said period of each channel with the static magnetic field intensity signal of said period comprises:
for the pilot tone signal of said period of each channel, calculating the absolute value of a first difference between a trough position of the pilot tone signal of said period of said channel and a trough position of the static magnetic field intensity signal of said period, calculating the absolute value of a second difference between a peak position of the pilot tone signal of said period of said channel and a peak position of the static magnetic field intensity signal of said period, and if the absolute value of the first difference is less than a second threshold and the absolute value of the second difference is less than a third threshold, determining that a respiration direction of the pilot tone signal of said channel is the same as a respiration direction of the static magnetic field intensity signal.

11. The apparatus as claimed in claim 7, **characterized in that** the comparison module respectively comparing the pilot tone signal of said period of each channel with the static magnetic field intensity signal of said period comprises:
subtracting a DC component of the static magnetic field intensity signal from the static magnetic field intensity signal of said period, obtaining positions of two zero points from a resulting difference signal, and summing a signal between the two zero points to obtain a first sum;
for the pilot tone signal of said period of each channel, subtracting a DC component of the pilot tone signal from the pilot tone signal of said period of said channel, obtaining positions of two zero points from a resulting difference signal, and summing a signal between the two zero points to obtain a second sum;
judging whether the first sum and the second sum are both positive or both negative, and if so, determining that a respiration direction of the pilot tone signal of said channel is the same as a respiration direction of the static magnetic field intensity signal.

12. The apparatus as claimed in claim 7, **characterized in that** the comparison module respectively comparing the pilot tone signal of said period of each channel with the static magnetic field intensity signal of said period comprises:
for the pilot tone signal of said period of each channel, simultaneously inputting the pilot tone signal of said period of said channel and the static magnetic field intensity signal of said period into a pre-trained respiration direction detection model, and if an output value of the model is greater than a fourth threshold, determining that a respiration direction of the pilot tone signal of said channel is the same as a respiration direction of the static magnetic field intensity signal.

13. A magnetic resonance imaging system, **characterized in that** the system comprises the apparatus for detecting a respiration direction of a pilot tone signal as claimed in any one of claims 7 - 12.
